Europäisches Patentamt

European Patent Office

Office européen des brevets

(19)

(11) **EP 0 732 751 A1**

(12) **EUROPEAN PATENT APPLICATION**

(43) Date of publication:
18.09.1996 Bulletin 1996/38

(51) Int. Cl.$^6$: **H01L 29/788**, H01L 29/49,
G11C 16/04

(21) Application number: 96103962.5

(22) Date of filing: 13.03.1996

(84) Designated Contracting States:
**DE FR GB**

(30) Priority: **13.03.1995 JP 52135/95**

(71) Applicant: **KABUSHIKI KAISHA TOSHIBA**
**Kawasaki-shi, Kanagawa-ken 210 (JP)**

(72) Inventor: **Sakagami, Eiiji,**
**c/o Kabushiki Kaisha Toshiba**
**Minato-ku, Tokyo 105 (JP)**

(74) Representative: **Zangs, Rainer E., Dipl.-Ing. et al**
**Hoffmann, Eitle & Partner**
**Arabellastrasse 4/VIII**
**81925 München (DE)**

(54) **Semiconductor memory device having metal-insulator transition film**

(57) A transistor device for a memory includes a metal-insulator transition film (11) made of a material which is transitional between metal and insulator. A semiconductor substrate (1) is made of P type single crystalline silicon. A source region (3) and a drain region (2), which are both N type impurity regions, are formed in the surface of the substrate (1) apart from each other. A first gate oxide film (10), the metal-insula- tor transition film (11), a second gate oxide film (12) and a gate electrode (13) of polysilicon are stacked in the named order on the substrate (1) between the source region (3) and the drain region (2). An insulating film (9) is so coated as to surround the gate electrode (13), the metal-insulator transition film (11), etc.

FIG. 1

EP 0 732 751 A1

## Description

The present invention relates to a semiconductor memory device, and, more particularly, to the cell structure of a nonvolatile semiconductor memory device which is prevented from causing over erasure at the time of erasing data, and how to use a memory device using this cell.

Recently, stacked gate type memory cells having floating gates become popular as memory cells of an electrically erasable and programmable nonvolatile memory (flash EEPROM). Those memory cells are generally called ETOX (EPROM with Tunnel OXide) cells.

For a flash memory using this floating gate type memory cells (also called cells), collective data erasing is carried out in the units of large blocks each including multiple cells. Therefore, a large variation in the threshold voltages of the cells would appear after erasing cell data due to a variation in cells' work shape (size), a variation in the thickness of the gate oxide film, a variation in the thickness of the insulating film between the control gate and floating gate, a variation in the impurity concentration of the erasure electrode (source in the case of an ETOX cell), etc.

Over erasing of data is critical particularly for a NOR type flash memory. Over erasing is the phenomenon that the threshold voltage of a cell becomes 0V or less than 0V. If an over-erased cell is connected to a bit line, a leak current from the bit line to the source line is caused, which may result in the malfunction of the semiconductor memory device. As a solution to this problem, a data erasing method using the self-convergence of the threshold voltage of each cell after data erased cells has been proposed (see S. Yamada et al., 1991 IEDM Tech. Dig. p. 307-310). This method narrows the distribution of the threshold voltage of cells so as to prevent over erasure from occurring on data-erased cells.

Over erasing also occurs in a NAND type flash memory. As a countermeasure to this problem, a technique of repeating erasure and verification multiple times has been proposed (Momodimi, et al., 1989 IEEE Journal of Solid State Circuits, vol. 24, p 1238; although this technique involves over-writing, it may be used to cope with over erasing). Such a countermeasure against over erasing requires a very complicated control circuit and increases the chip area.

Moreover, over erasing raises an undesirable problem from the viewpoint of reliability. For example, in programming data in an over-erased cell in a NOR type flash memory, a stronger electric field than the normal one is applied to the gate oxide film. Consequently, the degradation of the gate oxide film occurs earlier than expected, thus shortening the life against the number of cycles of program erase endurance of writing and erasing, as compared with the one which has taken the above-described countermeasure.

Because the over erasure of cell data is an inherent problem of the conventional nonvolatile semiconductor memory devices, as described above, the reliability of memory cells is degraded. The countermeasurement necessitates the provision of a complex circuit in the control system, which will result in an increase in the chip area.

Accordingly, it is an object of the present invention to provide a semiconductor memory device which requires no control system to cope with over erasure, has such a cell structure that be designed into an integrated circuit, and a method of using this semiconductor memory device.

The feature of this invention lies in a semiconductor memory element which is designed to prevent from causing over erasure and which comprises:

a semiconductor substrate;
a source region and a drain region provided apart from each other on a surface of the semiconductor substrate;
a gate electrode on the semiconductor substrate between the source region and the drain region;
an insulating film provided between the surface of the semiconductor substrate and the gate electrode; and
a metal-insulator transition film provided in the insulating film and being transitional between metal and an insulator in accordance with an amount of injected charges.

According to this invention, when charges are injected into the metal-insulator transition film by a tunnel current, the injection of hot electrons or the like, the transition film transits to metal. The transistor device according to this invention substantially functions like a floating gate type MOS transistor whose threshold voltage rises by the injected charges. When charges are discharged from the metal-insulator transition film by causing the tunnel current to the transistor device of this invention or some other method, this transition film transits to an insulator, preventing further discharge of the charges so that the threshold voltage of the transistor converges to a given voltage. Therefore, this invention, when adapted to memory cells of a memory device, can provide memory cells preventing from causing over erasure at the time of erasing data.

This invention can be more fully understood from the following detailed description when taken in conjunction with the accompanying drawings, in which:

FIG. 1 is a cross-sectional view of a semiconductor memory element according to this invention;
FIG. 2 is a diagram indicating the semiconductor memory element embodying this invention by a circuit symbol;
FIGS. 3A and 3B are projectional views showing a specific example of the essential portion of the semiconductor memory element of this invention;

FIG. 4 presents a first characteristic curve showing the relationship between the threshold voltage of the semiconductor memory element according to this invention and the amount of injected charges;

FIG. 5 presents a second characteristic curve showing the relationship between the threshold voltage of the semiconductor memory element according to this invention and the amount of injected charges;

FIG. 6 presents a third characteristic curve showing the relationship between the threshold voltage of the semiconductor memory element according to this invention and the amount of injected charges;

FIG. 7 is a cross-sectional view depicting the semiconductor memory element of this invention as adapted to a NOR type EEPROM cell;

FIG. 8 is a cross-sectional view illustrating the structures of the source and drain regions of the semiconductor memory element in FIG. 7;

FIG. 9 is a circuit block diagram showing an applicational example of a semiconductor memory element provided by this invention;

FIG. 10 is a circuit block diagram of a semiconductor memory device (system) to which the semiconductor memory element provided by this invention is adapted;

FIG. 11 is a first circuit diagram illustrating the alignment of memory cells to be adapted to the semiconductor memory device of this invention;

FIG. 12 is a second circuit diagram illustrating the alignment of memory cells to be adapted to the semiconductor memory device of this invention; and

FIG. 13 is a third circuit diagram illustrating the alignment of memory cells to be adapted to the semiconductor memory device of this invention.

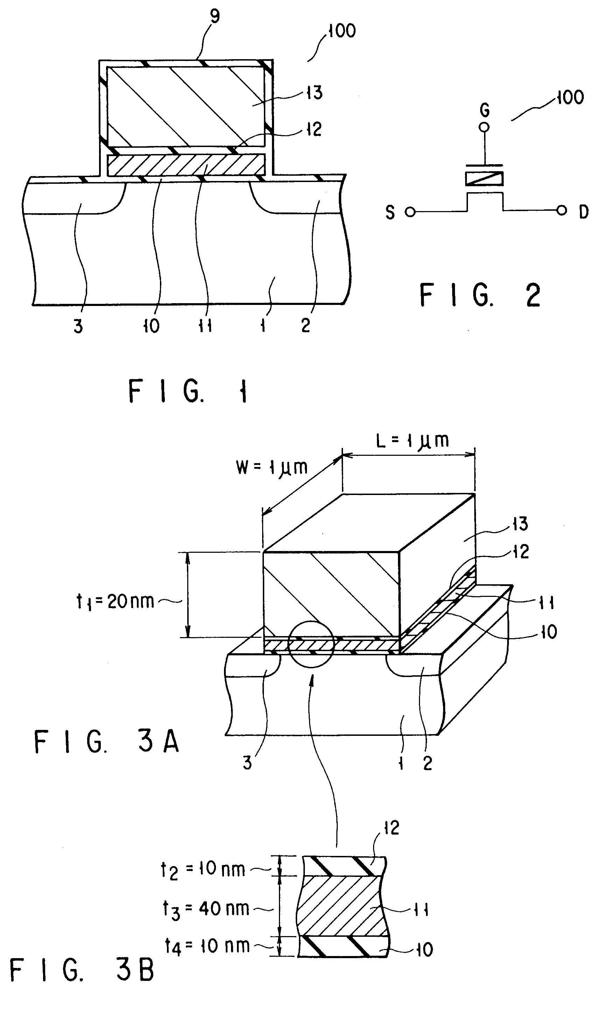

FIG. 1 presents a cross-sectional view showing the outline of a semiconductor memory element according to this invention. A semiconductor substrate 1 is made of P type single crystalline silicon. A drain region 2 and a source region 3, which are both N type impurity regions, are provided apart from each other on the surface of the substrate 1. A first gate oxide film 10, a metal-insulator transition film 11, a second gate oxide film 12 and a gate electrode 13 of polysilicon are stacked in the named order on the substrate 1 between the source region 3 and the drain region 2. The second gate oxide-film 12 provided between the metal-insulator transition film 11 and the gate electrode 13. An insulating film 9 is so coated as to surround the gate electrode 13, the metal-insulator transition film 11, etc. The insulating film 9 may be made of the same material as is used for the gate oxide films 10 and 12. FIG. 2 shows the semiconductor memory element 100 in FIG. 1 by a circuit symbol. The symbol in FIG. 2 will be used in the later description.

The metal-insulator transition film 11 in FIG. 1 is made of a material which causes transition between metal and an insulator by the injection of charges. One example of such a material is an amorphous silicon film doped with arsenic, phosphorous or antimony at a concentration of $10^{14}$ to $10^{19}$ cm$^{-3}$. Other possible materials for the metal-insulator transition film 11 include an amorphous germanium film doped with arsenic, phosphorous or antimony at a concentration of $10^{14}$ to $10^{19}$ cm$^{-3}$, an amorphous cadmium sulfide film doped with arsenic, phosphorous or antimony at a concentration of $10^{14}$ to $10^{19}$ cm$^{-3}$, and a gallium arsenide film doped with arsenic, phosphorous or antimony at a concentration of $10^{14}$ to $10^{19}$ cm$^{-3}$. Those films change to metal from an insulator by the injection of electrons and change to an insulator from metal by the discharge of electrons.

The injection of electrons into the metal-insulator transition film 11 is accomplished by the injection of hot electrons or using the tunnel current or the like, which will now be discussed with reference to FIG. 1. In the case of injecting hot electrons, for example, the potential of the substrate 1 is set to 0V, and 7V is applied to the drain region 2 at the same time as which 10V is applied to the gate electrode 13. In the case of using the tunnel current, for example, 20V is applied to the gate electrode 13 and 0V is applied to the substrate 1 and the source and drain regions 2 and 3. The injection of electrons into the metal-insulator transition film 11 allows this semiconductor memory element to substantially function like a floating gate type MOS transistor whose threshold voltage is increased by the injection of electrons into the MOS transistor.

The discharge of electrons from the metal-insulator transition film 11 is carried out by using the tunnel current or the like. For example, 0V or a negative voltage (e.g., -10V) is applied to the gate electrode 13, and 5V as a positive voltage is applied to the source region 3. It is desirable that an electric field of approximately 10 MV/cm be applied to the gate oxide film 10. When electrons are discharged in this manner, the metal-insulator transition film 11 transits or changes to an insulator when the number of the electrons in the transition film 11 becomes equal to or smaller than a given number, thus preventing a further discharge of the electrons. Therefore, the threshold voltage converges to a certain value at the time of discharging electrons.

The following will discuss the results of simulation on the relationship between the threshold voltage of the semiconductor memory element of this invention and the number of injected electrons, with reference to FIGS. 3 through 6.

FIGS. 3A and 3B are projectional views showing a specific shape and size of the essential portion of the semiconductor memory element used in the simulation. It is to be noted that the channel width W and channel length L are both 1 μm, the thickness $t_1$ of the gate electrode is 200 nm, and the thickness $t_2$ of the second oxide film, the thickness $t_3$ of the metal-insulator transition film and the thickness $t_4$ of the first oxide film are respectively 10 nm, 40 nm and 10 nm.

Hereinafter, the semiconductor memory element of this invention will be sometimes called "memory cell" or simply "cell."

The threshold voltage $V_{th}(I)$ of a cell when the metal-insulator transition film 11 is an insulator is given by the following equation.

$$V_{th}(I) = \frac{A}{\varepsilon_0 \varepsilon_{OX}} (t_4 + \frac{\varepsilon_{OX}}{\varepsilon_I} t_3 + t_2) \qquad (1)$$

where A is a constant which is determined mainly by the impurity profile of the channel, $\varepsilon_0$ is the dielectric constant of vacuum which is $8.85 \times 10^{-14}$ F/cm, $\varepsilon_{OX}$ is the specific dielectric constant of the oxide film which is approximately 4, $\varepsilon_I$ is the specific dielectric constant of the metal-insulator transition film after transition to an insulator which is approximately 8 when the transition film is made of one of the aforementioned members. By substituting those values into the equation (1), $V_{th}(I)$ becomes about 1.0V.

The threshold voltage $V_{th}(M)$ of a cell immediately after the metal-insulator transition film 11 changes to metal from an insulator is given by the following equation.

$$V_{th}(M) = \frac{C_1 + C_2}{C_2} \cdot \frac{A}{\varepsilon_0 \varepsilon_{OX}} t_4 + \frac{Q_{T1}}{C_2} \qquad (2)$$

where $C_1$ is the capacitance between the channel and the metalized member which is approximately 3.54 fF, $C_2$ is the capacitance between the gate electrode and the metalized film which, like $C_1$, is approximately 3.54 fF, and $Q_T$ is the amount of injected charges, i.e., electrons necessary for the transition which is approximately 4000. In this example, the doping amount of the transition film is adjusted so that $Q_{T1}$ becomes approximately 4000. As those values are substituted into the equation (2), the first term in the equation (2) becomes 0.5V and the second term becomes 0.2V so that $V_{th}(M)$ becomes 0.7V.

A change in the threshold voltage of a cell when the metal-insulator transition film 11 changes to metal from an insulator is given by the following equation.

$$V_{th}(M) - V_{th}(I) = \frac{A}{\varepsilon_0 \varepsilon_{OX}} (\frac{C_1}{C_2} t_4 - t_2) - \frac{A}{\varepsilon_0 \varepsilon_I} t_3 + \frac{Q_T}{C_2} \qquad (3)$$

As the aforementioned values are substituted into the equation (3), the change in the threshold voltage becomes -0.3V. When the amount of the injected charges exceeds $Q_{T1}$, the threshold voltage monotonously increases as in the case of the ordinary floating gate type MOS transistor. When the number of charges is 60000, the threshold voltage $V_{th}(H)$ of a cell becomes 3.5V from the equation (2).

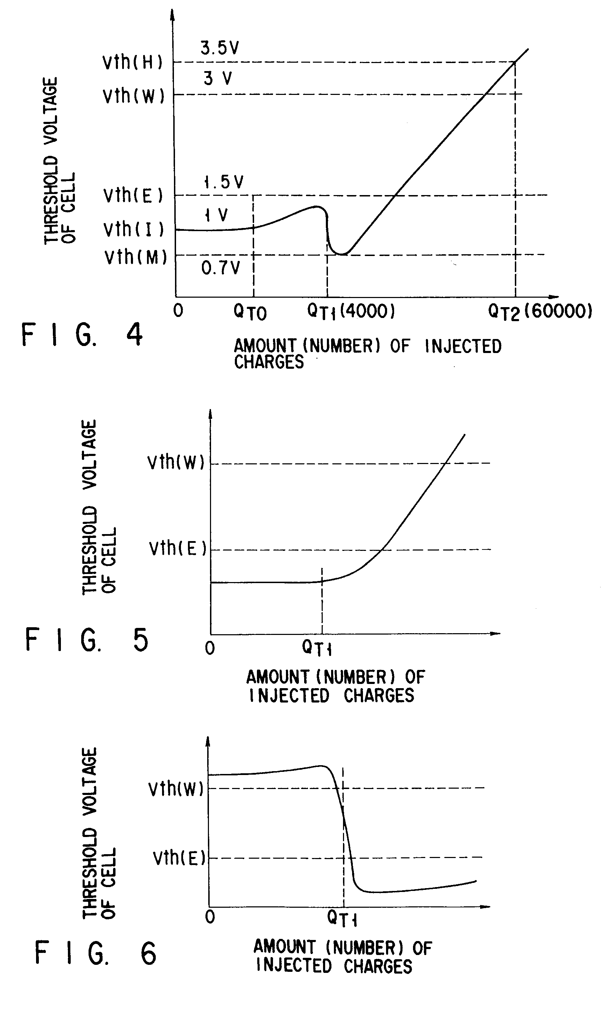

FIG. 4 presents a characteristic curve showing the relationship between the threshold voltage of a cell and the amount of injected charges as simulated based on the above-given values. Although the threshold voltage slightly increases by the electron trapping by the insulating film when the amount of charges as being injected exceeds $Q_{T0}$, the threshold voltage suddenly drops to about 0.7V when the amount of charges exceeds $Q_{T1}$ after which the threshold voltage increases monotonously as the charges are injected. It is apparent that when the charges are discharged, the threshold voltage converges to approximately 1V. In this case, 1-bit storage is possible if the lower limit of the threshold voltage, $V_{th}(W)$, of a data-programmed cell is set to 3V, the upper limit of the threshold voltage, $V_{th}(E)$, of a data-erased cell is set to 1.5V and the voltage to be applied to the word line or gate electrode in a read mode is set to lie between those two set voltages.

It is apparent from the equation (3) that the relationship between the threshold voltage of a cell and the amount of injected charges becomes as illustrated in FIG. 5 when the transition film 11 is thin and the transition is relatively gentle, not sharp. When the transition film 11 is thick and the transition is sharp, however, this relationship becomes as illustrated in FIG. 6. The former relationship is desirable when the convergence of the threshold voltage at the time of discharging charges is utilized. The latter relationship is desirable when a transition-originated variation in the threshold voltage of a cell is utilized as the mode of data storage.

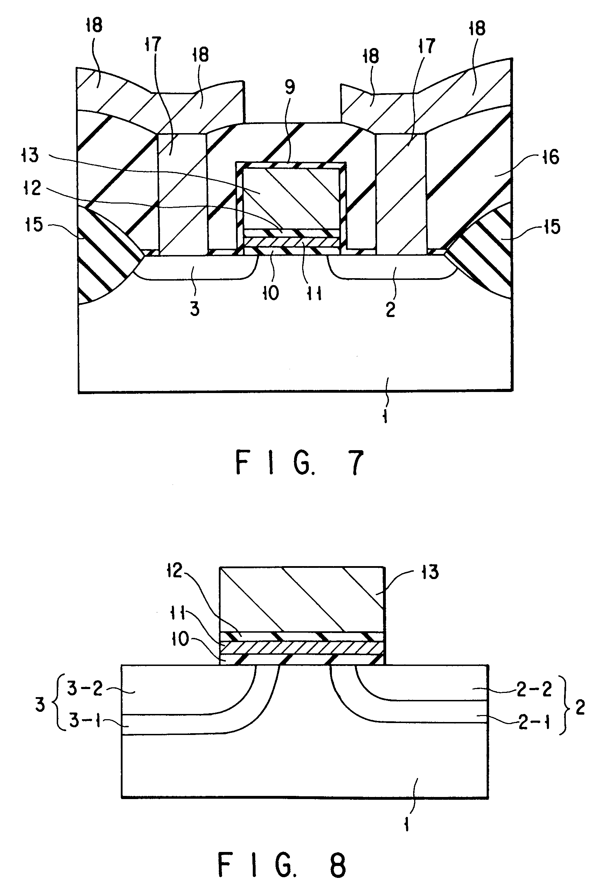

FIG. 7 is a cross-sectional view of the semiconductor memory element of this invention as adapted to a NOR type EEPROM cell. A device isolation region 15 is formed on a semiconductor substrate 1 of P type silicon at a predetermined area by a known method. A first oxide film 10 is formed in a memory cell area between the device isolation regions 15. This oxide film 10 is formed by the deposition of a silicon oxide film or the oxidization of the semiconductor substrate 1. Subsequently, amorphous silicon is deposited on the first oxide film 10 after which the resultant structure is doped with arsenic, phosphorous, antimony or the like at a predetermined concentration less than the concentration that causes metalization, thereby forming a layer 11 of a metal-insulator transition film. While ion injection or solid phase diffusion can be used as the doping method, the ion injection is more appropriate in order to properly adjust the concentration. A silicon oxide film is deposited on this transition film layer 11 to form a second oxide film 12. Consequently, the stacked gate insulating film structure is provided. To prevent electrons from leaking from the metalized transition film layer 11 directly by the tunnel current, the first and second oxide films 10 and 12 should have thicknesses of 5 nm or greater. The total thickness of both oxide films 10 and 12 should not however exceed 30 nm because they are used as the stacked gate insulating films when the transition film 11 becomes an insulator. The thickness of the transition film layer 11 should vary depending on which one of the characteristics shown in FIGS. 5 and 6 is to be acquired. The thickness of the transition film layer 11 should be equal to or greater than 5 nm and equal to or less than 60 nm when the characteristic in FIG. 5 is used and the thickness of the transition film layer 11 should be equal to or greater than 30 nm and equal to or less than 2 μm when the characteristic in FIG. 6 is used. The first and second oxide films 10 and 12 may be changed to NO (nitride-oxide) films, ONO (oxide-nitride-oxide) films, oxynitride films or the like, which are more desirable because they are stronger against electrical stress during the operation.

The patterning for isolating the metal-insulator transition film layer 11 between memory cells is to form so-called slits (not shown) as done for the floating gate. Subsequently, the gate electrode 13 of polysilicon is formed, the gates of the memory cells are patterned and the stacked gate insulating film is worked. To prevent any damage or impurity contamination from being caused by ion injection, the oxide film 9 is formed by thermal oxidization or deposition. Next, N type diffusion layers for the source 3 and drain 2 are formed by ion injection. The concentration and depth of the source and drain regions are changed depending on how to program data in the memory cells.

In executing erasure or drawing electrons from the transition film 11 by the tunnel current, the source region 3 is formed by a deep and low-concentration N type diffusion layer region 3-1 and a shallow and high-concentration N type diffusion layer region 3-2, as shown in FIG. 8. As a result, the area where the tunnel current flows expands to contribute to shortening the erasing time. In executing data writing or injecting electrons by using the hot electrons, the drain region 2 is formed by a deep and high-concentration P type diffusion layer region 2-1 (so-called P pocket) and a shallow and high-concentration N type diffusion layer region 2-2. As a result, hot carriers are efficiently generated, contributing to shortening the programming time.

In FIG. 7, after the formation of the source and drain regions, in accordance with the ordinary method of forming an MOS transistor, an interlayer insulating film 16 is formed, and a tungsten plug 17 is buried in a contact hole which reaches the source and drain after which a metal layer (aluminum) 18 is formed.

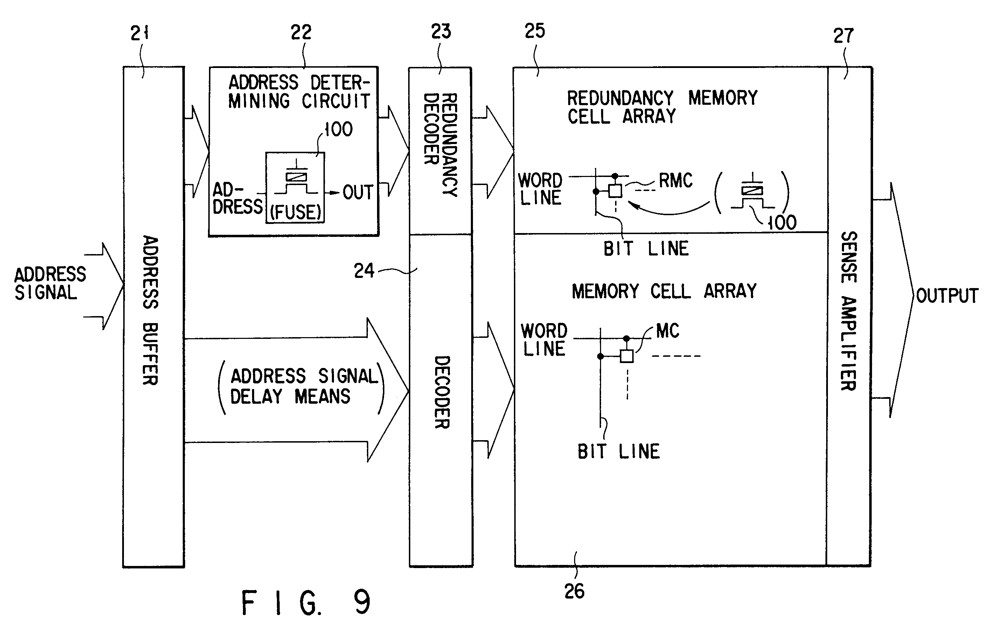

Although the foregoing description has been given of the case where this invention is adapted to a NOR type memory cell, this invention may of course be adapted to a NAND type memory cell and a fuse element. In the case where the memory element of this invention is adapted to a fuse element, for example, it is used as a switching element for a program for an address determining circuit 21 which determines whether or not to access to a memory cell in a redundancy memory cell array 25 in the memory device instead of a memory cell in a memory cell array 26 as shown in FIG. 9. The memory element 100 of this invention may be used as a memory cell in the redundancy memory cell array 25. The memory cell MC in the memory cell array 26 may be constituted by the memory element 100 of this invention, or may have a different structure.

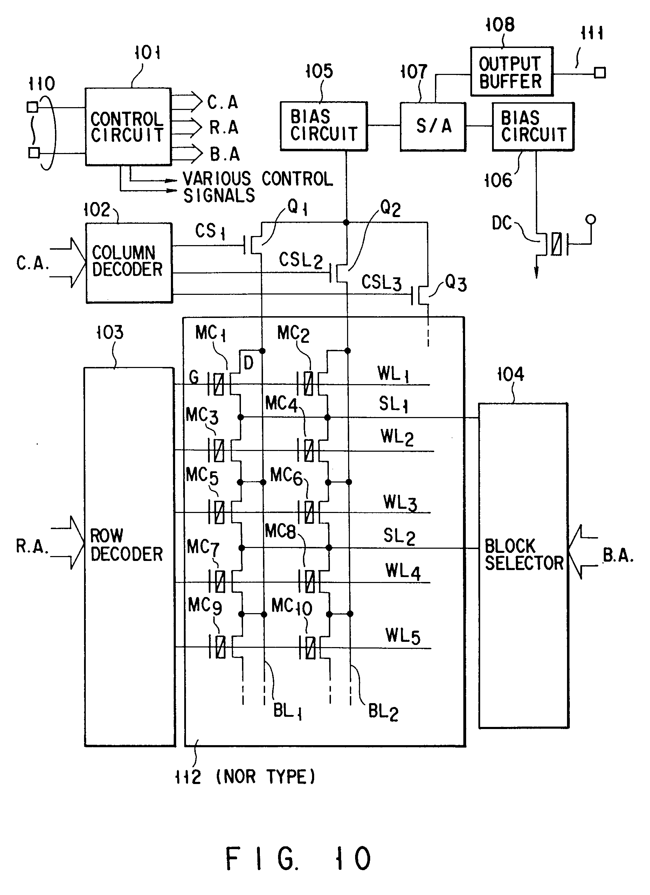

FIG. 10 is a circuit block diagram of a semiconductor memory device (system) to which the semiconductor memory element provided by this invention is adapted as a memory cell. A memory cell array 112 comprises memory cells MC1 to MC10. This memory cell array 112 employs a typical NOR type memory cell structure. The memory cells MC in the same column are connected to a bit line BL1, BL2 or the like. The memory cells MC in the same row are connected to a word line WL1, ..., WL5 or the like. A source select line (SL1, SL2 or the like) is connected to the memory cells MC of every other row, which have a common source. Bias circuits 105 and 106 supply the supply voltages. Column select transistors Q1 to Q3 are connected between the bias circuit 105 and the associated bit lines. The gate control of the column select transistors Q1 to Q3 is carried out by column select lines CSL1 to CSL3 connected to a column decoder 102. A row decoder 103 selectively enables the word lines (WL). A block selector 104 selectively enables the source select lines (SL). A control circuit 101 provides various circuits with control signals, and receives various external signals 110. A sense amplifier 107 compares data in the selected memory cell MC with data in a dummy cell DC in accordance with the address. To supply the proper reference potential to the sense amplifier 107, the bias ratios of the bias circuits 105 and 106 are set different from each other. The dummy cell has the same shape as the memory cells and is an MOS transistor including the metal-insulator transition film (11). The output of the sense amplifier 107 is transmitted to an output buffer 108 to be output to an external unit (from an input/output terminal 111).

The column decoder 102 selectively enables the column select lines CSL based on a column address signal C.A. The row decoder 103 selectively enables the word lines based on a row address signal R.A. The row decoder 103 supplies a high voltage (e.g., 10V) in a write mode, supplies the supply voltage (e.g., 3V) in a read mode, and supplies an erase voltage (e.g., -10V) in an erase mode. The bias circuit 105 supplies a high voltage (e.g., 7V) in the program mode. The block selector 104 sets the potential of the associated source select line to 0V in the read mode as well as the write mode and to 5V in the erase mode based on a block address B.A.

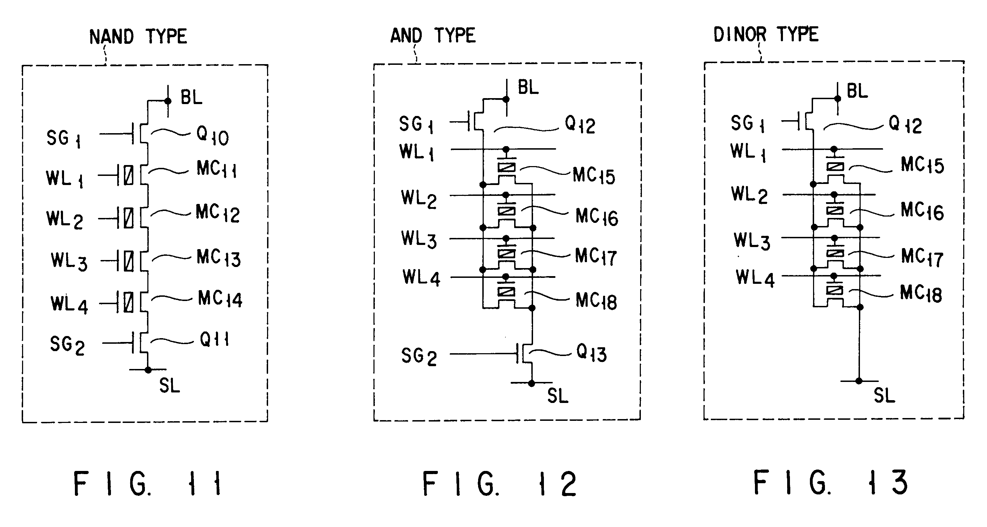

Although the foregoing description of this invention has been given of the system structure of a semiconductor memory device which employs the array of NOR type memory cells, this invention is not limited to this particular type but may take a NAND type memory cell structure shown in FIG. 11, an AND type memory cell structure shown in FIG. 12 and a DINOR (Divided NOR) type memory cell structure shown in FIG. 13 as well. In FIG. 11, a plurality of memory cells MC11 to MC14 are connected in series, a drain-side selecting transistor Q10, which is enabled by a select line SG1, is connected between the series circuit of the memory cells MC11-MC14 and a bit line BL, and a source-side selecting transistor Q11, which is enabled by a select line SG2, is connected between the series circuit of the memory cells and a source line SL. This NAND memory cell structure contributes to the reduction of the chip area. In FIG. 12, a plurality of memory cells MC15 to MC18 are connected in parallel, a drain-side selecting transistor Q12, which is enabled by a select line SG1, is connected between the parallel circuit of the memory cells MC15-MC18 and a bit line BL, and a source-side selecting transistor Q13, which is enabled by a select line SG2, is connected between the parallel circuit of the memory cells and a source line SL. The structure in FIG. 12 is a so-called AND memory cell structure. The structure in FIG. 13 is a DINOR type memory cell structure that is the same as the one in FIG. 12 from which the source-side selecting transistor Q13 is omitted. Both structures contribute to the reduction of the chip area.

Using the memory elements of this invention to constitute a nonvolatile memory device can eliminate over erasing of data without requiring an external control circuit. It is therefore possible to provide a semiconductor memory device, which can improve the reliability and shorten the erasing time without increasing the chip area.

## Claims

1. A semiconductor memory device comprising:

   a semiconductor substrate (1); and
   a transistor device (100) for a memory formed on said semiconductor substrate (1), characterized in that said transistor device (100) comprises:
   a source region (3) and a drain region (2) provided apart from each other on a surface of said semiconductor substrate (1);
   a first insulating film (10) provided on said surface of said semiconductor substrate (1) including a channel region between said source region (3) and said drain region (2);
   a metal-insulator transition film (11) on said first insulating film (10), said metal-insulator transition film (11) being formed of a member which is transitional between metal and an insulator in accordance with an amount of injected charges;
   a second insulating film (12) on said metal-insulator transition film (11); and
   a gate electrode (13) of a conductive member on said second insulating film (12).

2. The semiconductor memory device according to claim 1, characterized in that said metal-insulator transition film (11) is comprised of an amorphous silicon film doped with one of arsenic, phosphorous and antimony at a concentration of $10^{14}$ to $10^{19}$ cm$^{-3}$.

3. The semiconductor memory device according to claim 1, characterized in that said metal-insulator transition film (11) is comprised of an amorphous germanium film doped with one of arsenic, phosphorous and antimony at a concentration of $10^{14}$ to $10^{19}$ cm$^{-3}$.

4. The semiconductor memory device according to claim 1, characterized in that said metal-insulator transition film (11) is comprised of an amorphous cadmium sulfide film doped with one of arsenic, phosphorous and antimony at a concentration of $10^{14}$ to $10^{19}$ cm$^{-3}$.

5. The semiconductor memory device according to claim 1, characterized in that said metal-insulator transition film (11) is comprised of a gallium arsenide film doped with one of arsenic, phosphorous and antimony at a concentration of $10^{14}$ to $10^{19}$ cm$^{-3}$.

6. The semiconductor memory device according to claim 1, characterized in that said first insulating film (10) and said second insulating film (12) include any one of an oxide film, a double-layer film consisting of a nitride film and an oxide film, a three-layer film consisting of an oxide film, a nitride film and an oxide film, and an oxynitride film.

7. The semiconductor memory device according to claim 1, characterized in that said transistor device (100) is a programming fuse element (FUSE).

8. The semiconductor memory device according to claim 1, characterized in that a plurality of transistor devices (100) are provided as memory cells (MC).

9. The semiconductor memory device according to claim 8, characterized in that said transistor devices (100) are used as dummy cells (DC) whose output signals are to be compared with output signals of said memory cells.

10. The semiconductor memory device according to claim 1, characterized in that a plurality of transistor devices (100) are provided as redundancy memory cells (RMC) equivalent to memory cells to be accessed in place of predetermined memory cells.

11. The semiconductor memory device according to claim 10, characterized in that said transistor devices (100) are used as programming fuse elements (FUSE) for determining if said redundancy memory cells are to be accessed in place of said predetermined memory cells.

12. The semiconductor memory device according to claim 1, characterized in that said transistor device (100) is used as a memory cell (MC) with a NOR type memory cell structure (NOR TYPE).

13. The semiconductor memory device according to claim 1, characterized in that said transistor device (100) is used as a memory cell (MC) with a NAND type memory cell structure (NAND TYPE).

14. The semiconductor memory device according to claim 1, characterized in that said transistor device (100) is used as a memory cell (MC) with an AND type memory cell structure (AND TYPE).

15. The semiconductor memory device according to claim 1, characterized in that said transistor device (100) is used as a memory cell (MC) with a DINOR type memory cell structure (DINOR TYPE).

16. The semiconductor memory device according to claim 1, characterized in that a plurality of transistor devices (100, MC) are arranged in a matrix form to form a memory cell array (112) in which one ends (D) of current paths of said transistor devices commonly belonging to an arbitrary column are coupled to a common one of bit lines (BL), and gate electrodes (G) of said transistor devices commonly belonging to arbitrary rows are respectively coupled to common word lines (WL).

17. The semiconductor memory device according to claim 1, characterized in that a plurality of transistor devices (100, MC) are arranged in a matrix form to form a memory cell array (112) in which one ends (D) of current paths of said transistor devices commonly belonging to an arbitrary column are coupled to a common one of bit lines (BL), and gate electrodes (G) of said transistor devices commonly belonging to an arbitrary row are coupled to a common one of word lines (WL); and
further comprising a data erasing circuit (104) for separating said transistor devices (100, MC) to a plurality of groups and applying a predetermined voltage to source regions (S) of said transistor devices in each group.

18. The semiconductor memory device according to claim 1, characterized in that a plurality of transistor devices (100, MC) are arranged in a matrix form to form a memory cell array (112) in which one ends (D) of current paths of said transistor devices commonly belonging to an arbitrary column are coupled to a common one of bit lines (BL), and gate electrodes of said transistor devices commonly belonging to an arbitrary row are coupled to a common one of word lines (WL), with a select transistor (SG) provided between each bit line (BL) and said associated transistor devices (100, MC); and
further comprising a data erasing circuit (104) for separating said transistor devices (100, MC) to a plurality of groups and applying a predetermined voltage to source regions (S) of said transistor devices in each group.

19. The semiconductor memory device according to claim 1, characterized in that a plurality of transistor devices (100, MC) are arranged in a matrix form to form a memory cell array (112) having NAND type cell units (NAND TYPE) in which one end (D) of a current path of those series-connected transistor devices ($MC_{11}$ to $MC_{14}$) is connected to a select transistor ($SG_1$) belonging to an arbitrary column are, the other end of said current path is connected to a second select transistor ($SG_2$) belonging to an arbitrary source line (SL), and gate electrodes of said transistor devices commonly belonging to an arbitrary row are coupled to a common one of word lines ($WL_1$ to $WL_4$); and
further comprising a data erasing circuit (104) for separating said NAND type cell units (NAND TYPE) to a plurality of groups and applying a predetermined voltage to source regions of said transistor devices in each cell unit.

20. The semiconductor memory device according to claim 1, characterized in that a plurality of transistor devices (100, MC) are arranged in a matrix form to form a memory cell array (112) having AND type cell units (AND TYPE) in which one end (D) of a current path of those parallel-connected transistor devices ($MC_{15}$ to $MC_{18}$) is connected to a select transistor ($SG_1$) belonging to an arbitrary column are, the other end of said current path is connected to a second select transistor ($SG_2$) belonging to an arbitrary source line (SL), and gate electrodes of said transistor devices commonly belonging to an arbitrary row are coupled to a common one of word lines ($WL_1$ to $WL_4$); and

further comprising a data erasing circuit (104) for separating said AND type cell units (AND TYPE) to a plurality of groups and applying a predetermined voltage to source regions of said transistor devices in each cell unit.

21. The semiconductor memory device according to claim 1, characterized in that a plurality of transistor devices (100, MC) are arranged in a matrix form to form a memory cell array (112) having DINOR type cell units (DINOR TYPE) in which one end (D) of a current path of those parallel-connected transistor devices ($MC_{15}$ to $MC_{18}$) is connected to a select transistor ($SG_1$) belonging to an arbitrary column are, the other end of said current path is connected to a second select transistor ($SG_2$) belonging to an arbitrary source line (SL), and gate electrodes of said transistor devices commonly belonging to an arbitrary row are coupled to a common one of word lines ($WL_1$ to $WL_4$); and

further comprising a data erasing circuit (104) for separating said DINOR type cell units (DINOR TYPE) to a plurality of groups and applying a predetermined voltage to source regions of said transistor devices in each cell unit.

22. The semiconductor memory device according to claim 1, characterized in that injection of charges into said metal-insulator transition film (11) in said transistor device (100, MC) is accomplished by a tunnel current.

23. The semiconductor memory device according to claim 1, characterized in that injection of charges into said metal-insulator transition film (11) in said transistor device (100, MC) is accomplished by hot electrons.

24. The semiconductor memory device according to claim 1, characterized in that discharging of charges from said metal-insulator transition film (11) in said transistor device (100, MC) is accomplished by a tunnel current.

25. The semiconductor memory device according to claim 1, characterized in that said metal-insulator transition film (11) changes to a conductive film by respectively applying first and second predetermined voltages to said gate electrode and said drain region in which case a threshold voltage of said transistor device (100, MC) is so set as to converge within a first predetermined range, and said metal-insulator transition film (11) changes to an insulating film by applying a third predetermined voltage to said source region (3, S) or said channel region in which case said threshold voltage of said transistor device (100, MC) is so set as to converge within a second predetermined range.

EP 0 732 751 A1

F I G. 1

F I G. 2

F I G. 3 A

$L = 1 \mu m$

$W = 1 \mu m$

$t_1 = 20\,nm$

F I G. 3 B

$t_2 = 10\,nm$

$t_3 = 40\,nm$

$t_4 = 10\,nm$

9

EP 0 732 751 A1

FIG. 4

FIG. 5

FIG. 6

F I G. 7

F I G. 8

FIG. 9

F I G. 10

NAND TYPE

F I G. 1 1

AND TYPE

F I G. 1 2

DINOR TYPE

F I G. 1 3

EP 0 732 751 A1

EP 0 732 751 A1

| | European Patent Office | EUROPEAN SEARCH REPORT | Application Number EP 96 10 3962 |

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | EP-A-0 228 206 (ADVANCED MICRO DEVICES INC.)<br>* the whole document *<br>--- | 1-3 | H01L29/788<br>H01L29/49<br>G11C16/04 |
| A | EP-A-0 053 013 (FUJITSU LIMITED)<br>* the whole document *<br>--- | 1 | |
| A | EP-A-0 072 221 (THE UNIVERSITY COURT OF THE UNIVERSITY OF EDINBURGH)<br>* the whole document *<br>----- | 1-3 | |
| | | | TECHNICAL FIELDS SEARCHED (Int.Cl.6)<br><br>H01L |

The present search report has been drawn up for all claims

| Place of search | Date of completion of the search | Examiner |
|---|---|---|
| THE HAGUE | 19 June 1996 | Baillet, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

               

& : member of the same patent family, corresponding document

EPO FORM 1503 03.82 (P04C01)